# EUROPEAN PATENT APPLICATION

(11) **EP 4 538 797 A1**
(43) Date of publication of application: **16.04.2025**
(21) Application number: 23203062.7
(22) Date of filing: 11.10.2023
(51) Int. Cl.: G03F 7/20

(54) **METHOD OF DETERMINING A SAMPLING SCHEME AND ASSOCIATED METROLOGY METHOD**

(71) Applicant: ASML Netherlands B.V., 5500 AH Veldhoven (NL)
(72) Inventor: SELEN, Jori, Veldhoven (NL); DING, Jingqian, Veldhoven (NL); HAUPTMANN, Marc, Veldhoven (NL); WERKMAN, Roy, Veldhoven (NL)
(74) Representative: ASML Netherlands B.V.

(57) **Abstract**

Disclosed is a method of determining a sampling scheme for measuring at least one substrate or a portion thereof, the substrate being subject to a lithographic process to expose structures thereon using a lithographic apparatus comprising a measurement station for measuring the substrate and an exposure station for performing exposures on the substrate. The method comprises determining a correlation between measurement actions on said measurement station and exposed portions of said at least one substrate; determining an expected variability of a parameter of interest related to the lithographic process from said correlation; and determining the sampling scheme from said expected variability.

## Description

### BACKGROUND

### FIELD OF THE INVENTION

**0001** The present invention relates to control apparatus and control methods usable, for example, to maintain performance in the manufacture of devices by patterning processes such as lithography. The invention further relates to methods of manufacturing devices using lithographic techniques. The invention yet further relates to computer program products for use in implementing such methods.

### RELATED ART

**0002** A lithographic process is one in which a lithographic apparatus applies a desired pattern onto a substrate, usually onto a target portion of the substrate, after which various processing chemical and/or physical processing steps work through the pattern to create functional features of a complex product. The accurate placement of patterns on the substrate is a chief challenge for reducing the size of circuit components and other products that may be produced by lithography. In particular, the challenge of measuring accurately the features on a substrate which have already been laid down is a critical step in being able to position successive layers of features in superposition accurately enough to produce working devices with a high yield. So-called overlay should, in general, be achieved within a few tens of nanometers in today's sub-micron semiconductor devices, down to a few nanometers in the most critical layers.

**0003** Consequently, modern lithography apparatuses involve extensive measurement or 'mapping' operations prior to the step of actually exposing or otherwise patterning the substrate at a target location. So-called advanced alignment models have been and continue to be developed to model and correct more accurately non-linear distortions of the wafer 'grid' that are caused by processing steps and/or by the lithographic apparatus itself.

**0004** Alignment is typically measured using an alignment sensor within the lithographic apparatus. The alignment sensor measures positional information (alignment data) of periodic structures or alignment marks, such that an alignment model can be fitted to this alignment data. The alignment metrology may be applied sequentially with exposure (e.g., where the lithographic apparatus has only a single stage for (alignment) measurement and for exposure, or at least partially simultaneously (e.g., where the lithographic apparatus has separate measure and exposure stages).

**0005** It is also known to perform alignment metrology using a standalone alignment station. Such standalone alignment metrology may be performed inline (e.g., prior to each wafer exposure) and/or offline (e.g., on a subset of the exposed wafers).

**0006** In such lithographic processes, as well as other manufacturing processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

**0007** The manufacturing processes may be for example lithography, etching, deposition, chemical mechanical planarization, oxidation, ion implantation, diffusion or a combination of two or more of them.

**0008** Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

**0009** In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-infrared (IR) wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

**0010** Overlay metrology requires a decision to be made on which substrates to measure within a lot, and/or the positions and number of overlay targets to be measured per measured substrate. This should be done for each product and layer combination. The aim of the sample scheme is to measure overlay in each field with sufficient accuracy such that the desired overlay models can be fitted accurately and are representative of the overlay fingerprints of that product and layer combination.

**0011** It would be desirable to improve such overlay metrology methods.

### SUMMARY OF THE INVENTION

**0012** According to a first aspect of the present invention there is provided a method of determining a sampling scheme for measuring at least one substrate or a portion thereof, the substrate being subject to a lithographic process to expose structures thereon using a lithographic apparatus comprising a measurement station for measuring the substrate and an exposure station for performing exposures on the substrate; the method comprising: determining a correlation between measurement actions on said measurement station and exposed portions of said at least one substrate; determining an expected variability of a parameter of interest related to the lithographic process from said correlation; and determining the sampling scheme from said expected variability.

**0013** According to a second aspect of the present invention there is provided a method of metrology on one or more substrates, each substrate being subject to a lithographic process to expose structures thereon in a lithographic process using a lithographic apparatus; the method comprising: obtaining lithographic apparatus information relating to said lithographic process and/or lithographic apparatus prior to post-exposure measurement of said substrate; determining an expected variability of a parameter of interest from said lithographic apparatus information; and comprising assessing whether the expected variability is representative or an outlier; and excluding any metrology data relating to a substrate and/or portion thereof assessed to be an outlier from being used for feedback control of the lithographic process.

**0014** According to a third aspect of the present invention there is provided a computer program product containing one or more sequences of machine-readable instructions for implementing calculating steps in a method according to the first aspect of the invention as set forth above

**0015** The invention yet further provides a processing arrangement and lithographic apparatus comprising the computer program of the second aspect.

**0016** These and other aspects and advantages of the apparatus and methods disclosed herein will be appreciated from a consideration of the following description and drawings of exemplary embodiments.

### BRIEF DESCRIPTION OF THE DRAWINGS

**0017** Embodiments of the invention will now be described, by way of example only, with reference to the accompanying schematic drawings in which corresponding reference symbols indicate corresponding parts, and in which:
Figure 1 depicts a lithographic apparatus suitable for use in an embodiment of the present invention;
Figure 2 depicts a lithographic cell or cluster in which an inspection apparatus according to the present invention may be used;
Figure 3 illustrates schematically measurement and exposure processes in the apparatus of Figure 1, according to known practice; and
Figure 4 illustrates conceptually a method according to an embodiment of the invention.

### DETAILED DESCRIPTION OF EXEMPLARY EMBODIMENTS

**0018** Before describing embodiments of the invention in detail, it is instructive to present an example environment in which embodiments of the present invention may be implemented.

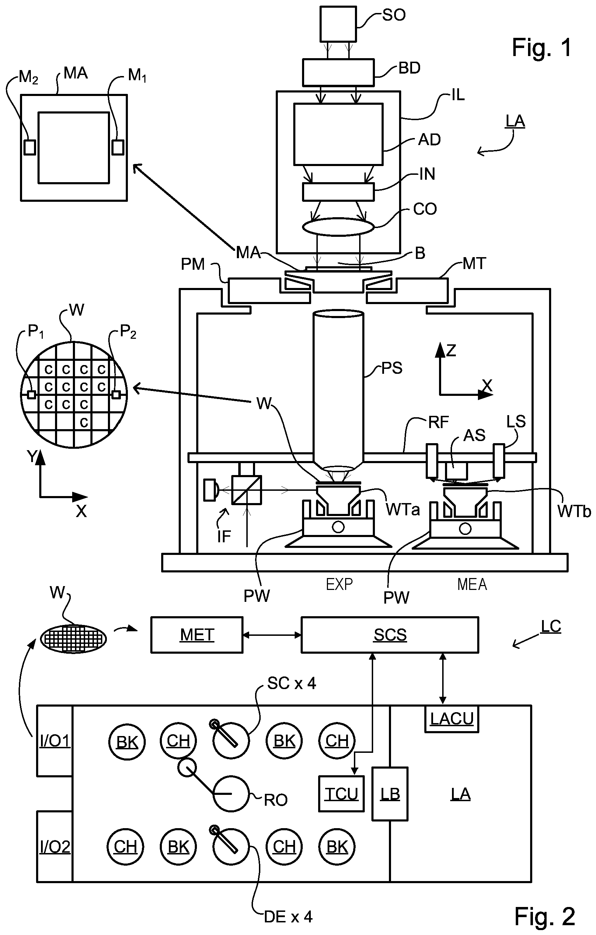

**0019** Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables WTa and WTb (e.g., a substrate support or substrate/wafer table), each comprising a plurality of burls on a support surface and each constructed to hold a substrate (e.g., a resist coated wafer) W; and a projection system (e.g., a refractive projection lens system) PS configured to project a pattern imparted to the radiation beam B by patterning device MA onto a target portion C (e.g., including one or more dies) of the substrate W. Each substrate table may be connected to a second positioner PW configured to accurately position the substrate in accordance with certain parameters. A reference frame RF connects the various components, and serves as a reference for setting and measuring positions of the patterning device and substrate and of features on them.

**0020** The illumination system may include various types of optical components, such as refractive, reflective, magnetic, electromagnetic, electrostatic or other types of optical components, or any combination thereof, for directing, shaping, or controlling radiation. For example, in an apparatus using extreme ultraviolet (EUV) radiation, reflective optical components will normally be used.

**0021** The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

**0022** The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

**0023** As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

**0024** The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

**0025** The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

**0026** In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

**0027** The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

**0028** The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

**0029** Patterning device (e.g., mask) MA and substrate W may be aligned using mask alignment structures or alignment marks M1, M2 and substrate alignment structures or alignment marks P1, P2. Although the substrate alignment structures as illustrated occupy dedicated target portions, they may be located in spaces between target portions (these are known as scribe-lane alignment structures). Similarly, in situations in which more than one die is provided on the patterning device (e.g., mask) MA, the mask alignment structures may be located between the dies. Small alignment structures may also be included within dies, in amongst the device features, in which case it is desirable that the markers be as small as possible and not require any different imaging or process conditions than adjacent features. The alignment system, which detects the alignment structures, is described further below.

**0030** The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

**0031** Combinations and/or variations on the above described modes of use or entirely different modes of use may also be employed.

**0032** Lithographic apparatus LA is of a so-called dual stage type which has two substrate tables WTa, WTb and two stations - an exposure station EXP on the exposure side and a measurement station MEA on the measure side- between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. On a single stage apparatus, the preparatory steps and exposure steps need to be performed sequentially on the single stage, for each substrate. The preparatory steps may include mapping the surface height contours of the substrate using a level sensor LS and measuring the position of alignment structures on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

**0033** As shown in Figure 2, the lithographic apparatus LA forms part of a lithographic cell LC, also sometimes referred to a lithocell or cluster, which also includes apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

**0034** In order that the substrates that are exposed by the lithographic apparatus are exposed correctly and consistently, it is desirable to inspect exposed substrates to measure properties such as overlay between subsequent layers, line thicknesses, critical dimensions (CD), etc. Accordingly a manufacturing facility in which lithocell LC is located also includes metrology system MET which receives some or all of the substrates W that have been processed in the lithocell. Metrology results are provided directly or indirectly to the supervisory control system SCS. If errors are detected, adjustments may be made to exposures of subsequent substrates.

**0035** Within metrology system MET, an inspection apparatus is used to determine the properties of the substrates, and in particular, how the properties of different substrates or different layers of the same substrate vary from layer to layer. The inspection apparatus may be integrated into the lithographic apparatus LA or the lithocell LC or may be a stand-alone device. To enable most rapid measurements, it may be desirable that the inspection apparatus measure properties in the exposed resist layer immediately after the exposure. However, not all inspection apparatus have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

**0036** The metrology step with metrology system MET can also be done after the resist pattern has been etched into a product layer. The latter possibility limits the possibilities for rework of faulty substrates but may provide additional information about the performance of the manufacturing process as a whole.

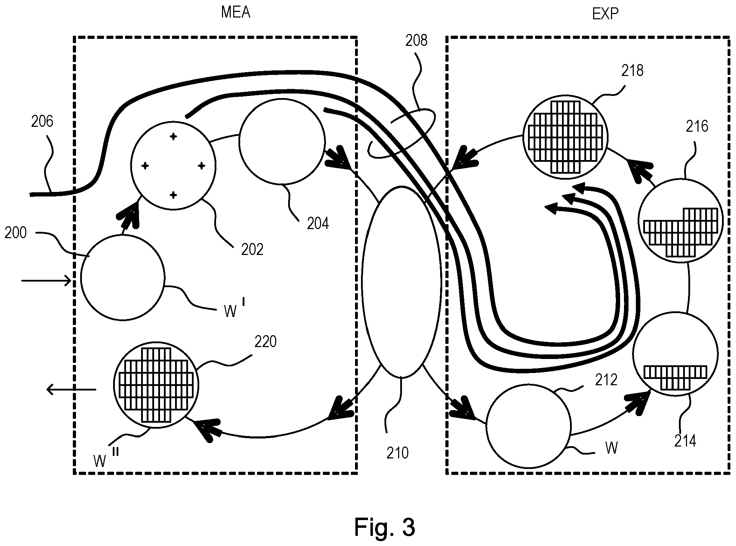

**0037** Figure 3 illustrates the steps to expose target portions (e.g. dies) on a substrate W in the dual stage apparatus of Figure 1. The process according to conventional practice will be described first. The present disclosure is by no means limited to dual stage apparatus of the illustrated type. The skilled person will recognize that similar operations are performed in other types of lithographic apparatus, for example those having a single substrate stage and a docking metrology stage.

**0038** On the left hand side (measure side) within a dotted box are steps performed at measurement station MEA, while the right hand side (exposure side) shows steps performed at exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

**0039** Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. Each patterning step can introduce positional deviations in the applied pattern, while subsequent processing steps progressively introduce distortions in the substrate and/or the pattern applied to it that must be measured and corrected for, to achieve satisfactory overlay performance.

**0040** The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation. Some layers may be patterned by steps that are alternative or supplementary to exposure in the illustrated lithographic apparatus. Such alternative and supplementary techniques include for example imprint lithography, self-aligned multiple patterning and directed self-assembly. Similarly, other processing steps performed per layer (e.g., CMP and etch) may be performed on different apparatuses per layer.

**0041** At 202, alignment measurements using the substrate marks P1 etc. and image sensors (not shown) are used to measure and record alignment of the substrate relative to substrate table WTa/WTb. In addition, several alignment structures across the substrate W' will be measured using alignment sensor AS. These measurements are used in one embodiment to establish a substrate model (sometimes referred to as the "wafer grid"), which maps very accurately the distribution of marks across the substrate, including any distortion relative to a nominal rectangular grid.

**0042** At step 204, a map of substrate height (Z) against X-Y position is measured also using the level sensor LS. Primarily, the height map is used only to achieve accurate focusing of the exposed pattern. It may be used for other purposes in addition.

**0043** When substrate W' was loaded, recipe data 206 were received, defining the exposures to be performed, and also properties of the substrate and the patterns previously made and to be made upon it. Where there is a choice of alignment structures on the substrate, and where there is a choice of settings of an alignment sensor, these choices are defined in an alignment recipe among the recipe data 206. The alignment recipe therefore defines how positions of alignment structures are to be measured, as well as which marks.

**0044** At 210, substrates W' and W are swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment structures M1, M2. In steps 214, 216, 218, scanning motions and radiation pulses are applied at successive target locations across the substrate W, in order to complete the exposure of a number of patterns.

**0045** By using the alignment data and height map obtained at the measuring station in the performance of the exposure steps, these patterns are accurately aligned with respect to the desired locations, and, in particular, with respect to features previously laid down on the same substrate (i.e., to ensure good overlay performance). The exposed substrate, now labeled W" is unloaded from the apparatus at step 220, to undergo etching or other processes, in accordance with the exposed pattern.

**0046** To monitor whether overlay is within specification and provide process control corrections, overlay metrology may be performed on the exposed structures (e.g., on proxy structures such as overlay structures (overlay targets), although overlay metrology can be performed directly on functional product structures; the methods described herein are applicable to either approach. As such, a target in the context of this disclosure may comprise a proxy structure exposed specifically for the purposes of parameter of interest (e.g., overlay) metrology or any structure used for parameter of interest (e.g., overlay) metrology.

**0047** In the absence of overlay error (and assuming a perfect target), a DBO target will be symmetrical and the incident measurement radiation will be diffracted equally into each of a pair of complementary diffraction orders, such that when measured they each have the same intensity (or other suitable measurement parameter). Any overlay will result in the diffraction orders being imbalanced. As such, the overlay may be determined from a determination of this imbalance (e.g., in terms of an intensity difference in the +1 and -1 diffraction orders or an asymmetry in a measurement pupil). In practical implementations, pairs of biased DBO targets may be used to, e.g., to help distinguish overlay from other asymmetries in the target.

**0048** An alternative or complementary overlay metrology method comprises image based overlay (IBO). This method typically measures the relative position of structures in respective different layers using imaging techniques. IBO targets may, for example, comprise box-in-box structures, gratings (spatially separated in the substrate plane) or any other suitable structure. It can be appreciated that as IBO targets do not relay on diffraction, gratings/periodic structures are not required.

**0049** These are only examples of overlay metrology techniques and it can be appreciated that the concepts disclosed herein are applicable to any overlay metrology technique or any relevant parameter of interest metrology technique.

**0050** Exposures performed on lithographic apparatuses or scanners, such as illustrated in Figure 1, suffer from so-called measure-to-expose (M2E) crosstalk. Movements of the measure side (measurement station) chuck create pressure waves which influence hardware elements such as the lens at the exposure side (exposure station), which ultimately impacts overlay. This overlay impact manifests mainly in an increase in overlay variation and is particularly pronounced when the measure side chuck has to accelerate and decelerate frequently, for example during Fine Wafer Alignment (FIWA) measurements.

**0051** It can be appreciated that timings on the measure side are not static, and has some intrinsic variability. For example, non-default measurements, such as process dependency gain/offset correction or global level contour measurements may be performed unpredictably or non-routinely. Individual measurements can fail unpredictably, resulting in a redo or fallback. Substrates may be delivered to the measure side with a delay which can result in a different start time of the measure sequence. Machine hardware and/or software can be upgraded or changed, resulting in a different measure sequence or faster stages with different timings.

**0052** Overlay metrology may rely on a suitable sample scheme to be determined for all product and layer combinations. A sample scheme may describe the measurement strategy for a particular field and/or substrate, e.g., how densely to measure and/or where to measure). A disadvantage of present sample scheme setup schemes is that they require costly dense overlay metrology for each product and layer combination. A mature fabrication plant may run many hundreds of products over a relatively short period (e.g., a few years), each comprising tens of layers. This may result in many thousands of combinations of products and layers. Depending on the strategy, dense overlay metrology may be performed at least once and possibly multiple times for each of the layers (independent of products), with multiple measurements per combination of products and layers. These sample scheme setups are typically one-time efforts and therefore are not updated when anything changes the overlay variation per field, such as timing changes or upgrades to machines mentioned in the preceding paragraph.

**0053** It is therefore proposed herein to determine a sample scheme, e.g., per field of a substrate, based on the performed measurement actions on a measurement side of a lithographic apparatus while fields are exposed on the exposure side of the lithographic apparatus. Each exposed field on the substrate may be correlated or associated with a measurement action on the measure side. The sampling scheme or measurement scheme for each exposure field can then be determined or selected based on the measurement action associated with that field (e.g., the measurement action which was being performed when that field was being exposed). Assuming that this substrate is then scheduled for overlay metrology, the metrology may be performed in accordance with the sampling scheme determined for each (or at least some) of its fields.

**0054** The correlation of measurement actions and exposure fields may be performed by comparing or correlating the lithographic apparatus timing data, e.g., as recorded within the apparatus log (scanner log data), for each side of the lithographic apparatus. As such, by combining the timings of measurement actions and field exposures, it may be straightforward to determine which fields are exposed during each measurement action.

**0055** The sampling scheme may be chosen based on a known or determined impact of each measurement action on overlay variability. For example, measurement actions associated with high overlay variability may be measured more densely, while those with low overlay variability may be measured sparsely, if at all. This may be assessed by performing (e.g., in a one-time calibration stage) each measurement action during exposure of a number of wafers, measuring each of these wafers and determining the resultant overlay variability per measurement action to determine calibration variability data. This overlay variability per measurement action may also be determined from historic lithographic apparatus and metrology data (historic variability data). Alternatively or in combination, the overlay variability per measurement action may be estimated based on, e.g., expert knowledge. For example, overlay variability may be estimated from the known (chuck) movements associated with each measurement action, e.g., the number of accelerations/decelerations and/or the magnitude of the accelerations/decelerations.

**0056** In another example, given a desired overlay model, an expected overlay variation per field and a budget for the total number of overlay measurements per wafer, an optimal sample scheme can be determined using existing techniques, e.g., using an uncertainty metric such as normalized model uncertainty. In particular, such a method may comprise minimizing normalized model uncertainty in an optimization, e.g., by minimizing the impact that variations in the measurements have on variations in the model predictions.

**0057** Any changes in the set of measurement actions can be monitored, and their impact can be calculated using any of the methods already described.

**0058** A sample scheme is described which effectively minimizes the impact of M2E on the accuracy of the model fitted to the measurements and used for overlay control. Such a sample scheme can be varied dynamically (e.g., in real-time) in accordance with any changes to measurement actions or the measurement schedule on the measure side.

**0059** Using the concepts disclosed, costly dense overlay measurements per product and layer combination are no longer necessary, or can at least heavily be reduced, since the proposed method eliminates a source of overlay variation coming from the scanner. In a rework scenario, the measurement budget can be targeted to where the benefit is the greatest. e.g., where the need for noise suppression in the greatest. Sample schemes can be generated with actual measure side timings, such that they automatically adapt to any changes in timings on the measure side. Users may freely experiment with alternative measure side settings or scanner upgrades without having to redo the sample scheme setup.

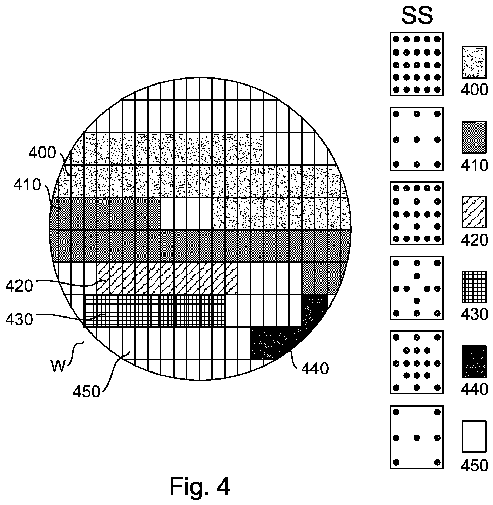

**0060** Figure 4 schematically indicates the concepts herein. The figure shows a substrate W comprising multiple fields 400, 410, 420, 430, 440, 450. The shading indicates what is happening on the measure side when each field is exposed. Next to the substrate are example sample schemes for each field in accordance with a corresponding measurement action. For example, white fields 450 are standstill fields exposed when the measurement chuck is stationary; its corresponding sampling scheme SS is the most sparse of those illustrated. Light shaded fields 400 exposed during FIWA measurement actions are the most densely sampled. Other fields 410, 420, 430, 440 correspond to other measurement actions taking place during the field exposure. These include for example, *inter alia,* leveling 410, coarse wafer alignment (COWA) 420, encoder measurement system inconsistency (EMSI) 430 and stage align 440. Also shown are exemplary sampling schemes SS proposed for each of these fields, e.g., based on an estimated impact of these measurement actions on the overlay variability within these fields.

**0061** Another measurement action which has a M2E impact may comprise the loading of a closing wafer on the measurement side, e.g., immediately after the final production wafer of a lot. Such a closing wafer may be a dummy wafer which ensures that the chuck remains loaded, which is desirable for some lithographic apparatuses (e.g., immersion apparatuses). Such closing wafers may fill up gaps in or at the end of a batch/lot or substrates to be exposed by the lithographic apparatus. However, these closing wafers can be responsible for a significant overlay variation in the wafer being exposed due to M2E crosstalk. The effect may be sufficiently significant that, in addition to adapting the sampling scheme as has been described, other decisions may be made as to how such overlay information may be used. **0062** For example, if the overlay impact of any measurement action or any other action is sufficiently large, small or in general different from regular measurement actions as to be unrepresentative (i.e. an outlier), then it may be preferable to exclude such unrepresentative overlay measurements from being relied upon for feedback control. As such, expected outlier metrology data may be excluded from the processing control loop (e.g., advanced process control (APC) loop), to keep the APC representative of wafer performance within lot production. However, it may be desirable that these outlier fields are actually measured, e.g., to assess whether rework is required.

**0063** Therefore the adaptive sampling method may predict whether a particular substrate or portion thereof (e.g., one or more fields) are likely to be outliers or unrepresentative, e.g., having a particularly high estimated overlay variation. It can then be decided to simply not measure these substrates and/or fields, or to designate them as monitoring only substrates/fields. Monitoring only substrates/fields would have their corresponding overlay data used only for monitoring, e.g., to make rework decisions, and not used for any control loop or feedback control.

**0064** Therefore a method is proposed which passes all lithographic apparatus information relating to exposure of the substrate or a portion thereof (e.g., one or more fields) from the lithographic apparatus prior to the lot being measured (i.e., post-exposure metrology such as overlay metrology). The information can comprise details on different root causes such as *inter alia* typical measure sequence, determined/correlated measure sequence (e.g., using the methods described above), determined or estimated localized thermal impacts. The method may comprise estimating whether the substrate and/or any fields thereon may be expected to have outlier fingerprint variation. The method may then decide not to include any metrology data relating to a substrate and/or field(s) expected to have outlier fingerprint variation from being used for feedback control. This may comprise not measuring such substrate and/or field(s), or determining them as monitoring only, as has been described.

**0065** In association with the hardware of the lithographic apparatus and the lithocell LC, an embodiment may include a computer program containing one or more sequences of machine-readable instructions for causing the processors of the lithographic manufacturing system to implement methods of model mapping and control as described above. This computer program may be executed for example in a separate computer system employed for the image calculation/control process. Alternatively, the calculation steps may be wholly or partly performed within a processor a metrology tool, and/or the control unit LACU and/or supervisory control system SCS of Figures 1 and 2. There may also be provided a data storage medium (e.g., semiconductor memory, magnetic or optical disk) having such a computer program stored therein in non-transient form.

**0066** Further embodiments of the invention are disclosed in below mentioned list of numbered clauses:
1. A method of determining a sampling scheme for measuring at least one substrate or a portion thereof, the substrate being subject to a lithographic process to expose structures thereon using a lithographic apparatus comprising a measurement station for measuring the substrate and an exposure station for performing exposures on the substrate; the method comprising:
   determining a correlation between measurement actions on said measurement station and exposed portions of said at least one substrate;
   determining an expected variability of a parameter of interest related to the lithographic process from said correlation; and
   determining the sampling scheme from said expected variability.
2. A method according to clause 1, wherein said determining a correlation comprises determining which measurement actions are performed by said measurement station during exposure of each exposed portion of said at least one substrate by said exposure station.
3. A method according to clause 1 or 2, wherein said determining a correlation comprises comparing timing data from said measurement station and said exposure station of said lithographic apparatus.
4. A method according to any preceding clause, wherein the sample density of the sample scheme for substrate or portion thereof is dependent on said expected variability.
5. A method according to any preceding clause, wherein the sample density of the sample scheme is increased for increased expected variability.
6. A method according to any preceding clause, wherein, for a desired parameter of interest model, an expected parameter of interest variation per region and a budget for the total number of parameter measurements per wafer:
   determining an uncertainty metric for various sample schemes, and
   determining the sample scheme as that which minimizes the uncertainty metric.
7. A method according to clause 6, wherein the uncertainty metric is normalized model uncertainty.
8. A method according to any preceding clause, wherein said determining an expected variability comprises determining the expected variability with reference to historic variability data and/or calibration variability data relating to said lithographic process.
9. A method according to any preceding clause, wherein said determining an expected variability comprises determining the expected variability based on known movements associated with each measurement action.
10. A method according to any preceding clause, wherein the parameter of interest is overlay.
11. A method according to any preceding clause, comprising assessing whether the expected variability is representative or an outlier; and
   excluding any metrology data relating to a substrate and/or portion thereof assessed to be an outlier from being used for feedback control of the lithographic process.
12. A method according to clause 11, wherein said excluding metrology data comprises not measuring substrate and/or portion thereof assessed to be an outlier.
13. A method according to clause 11, wherein said excluding metrology data comprises designating said substrate and/or portion thereof assessed to be an outlier for monitoring only, such that said substrate and/or portion thereof is measured but the resultant metrology data not used for said feedback control of the lithographic process.
14. A method according to clause 13, wherein said resultant metrology data is assessed to determine whether said substrate requires rework.
15. A method according to any preceding clause, wherein each said portion comprises an exposure field.
16. A method according to any preceding clause, wherein said method is performed in real-time during said lithographic process, such that sampling scheme is determined dynamically in response to any unscheduled measurement actions or variation in a schedule and/or timing of measurement actions performed on each substrate.
17. A method according to any preceding clause, comprising measuring said substrate or portion thereof in accordance with said sampling scheme.
18. A method of metrology on one or more substrates, each substrate being subject to a lithographic process to expose structures thereon in a lithographic process using a lithographic apparatus; the method comprising:
   obtaining lithographic apparatus information relating to said lithographic process and/or lithographic apparatus prior to post-exposure measurement of said substrate;
   determining an expected variability of a parameter of interest from said lithographic apparatus information; and
   comprising assessing whether the expected variability is representative or an outlier; and
   excluding any metrology data relating to a substrate and/or portion thereofa assessed to be an outlier from being used for feedback control of the lithographic process.
19. A method according to clause 18, wherein said excluding metrology data comprises not measuring substrate and/or portion thereof assessed to be an outlier.
20. A method according to clause 18, wherein said excluding metrology data comprises designating said substrate and/or portion thereof assessed to be an outlier for monitoring only, such that said substrate and/or portion thereof is measured but the resultant metrology data not used for said feedback control of the lithographic process.
21. A method according to any of clauses 18 to 20, wherein said resultant metrology data is assessed to determine whether said substrate requires rework.
22. A method according to any of clauses 18 to 21, wherein each said portion comprises an exposure field.
23. A method according to any of clauses 18 to 22, wherein the parameter of interest is overlay.
24. A computer program comprising program instructions operable to perform the method of any preceding clause, when run on a suitable apparatus.
25. A non-transient computer program carrier comprising the computer program of clause 24.
26. A processing arrangement comprising:
   a computer program carrier comprising the computer program of clause 25; and
   a processor operable to run said computer program.
27. A lithographic apparatus comprising:
   a measurement station for measuring the substrate;
   an exposure station for performing exposures on the substrate; and
   the processing arrangement operable to perform the method of any of clauses 1 to 16.
28. A lithographic cell, comprising:
   the lithographic apparatus of clause 27; and
   a metrology device operable to perform the measuring of clause 17.

**0067** Although specific reference may have been made above to the use of embodiments of the invention in the context of optical lithography, it will be appreciated that the invention may be used in other patterning applications, for example imprint lithography. In imprint lithography, topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

**0068** The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

**0069** The breadth and scope of the present invention should not be limited by any of the above described exemplary embodiments, but should be defined only in accordance with the following claims and their equivalents.

## Claims

1. A method of determining a sampling scheme for measuring at least one substrate or a portion thereof, the substrate being subject to a lithographic process to expose structures thereon using a lithographic apparatus comprising a measurement station for measuring the substrate and an exposure station for performing exposures on the substrate; the method comprising:
determining a correlation between measurement actions on said measurement station and exposed portions of said at least one substrate;
determining an expected variability of a parameter of interest related to the lithographic process from said correlation; and
determining the sampling scheme from said expected variability.

2. A method as claimed in claim 1, wherein said determining a correlation comprises determining which measurement actions are performed by said measurement station during exposure of each exposed portion of said at least one substrate by said exposure station.

3. A method as claimed in claim 1 or 2, wherein said determining a correlation comprises comparing timing data from said measurement station and said exposure station of said lithographic apparatus.

4. A method as claimed in any preceding claim, wherein the sample density of the sample scheme for substrate or portion thereof is dependent on said expected variability.

5. A method as claimed in any preceding claim, wherein the sample density of the sample scheme is increased for increased expected variability.

6. A method as claimed in any preceding claim, further comprising, for a desired parameter of interest model, an expected parameter of interest variation per region and a budget for the total number of parameter measurements per wafer:
determining an uncertainty metric for various sample schemes, and
determining the sample scheme as that which minimizes the uncertainty metric.

7. A method as claimed in claim 6, wherein the uncertainty metric is normalized model uncertainty.

8. A method as claimed in any preceding claim, wherein said determining an expected variability comprises determining the expected variability with reference to historic variability data and/or calibration variability data relating to said lithographic process.

9. A method as claimed in any preceding claim, wherein said determining an expected variability comprises determining the expected variability based on known movements associated with each measurement action.

10. A method as claimed in any preceding claim, wherein the parameter of interest is overlay.

11. A method as claimed in any preceding claim, comprising assessing whether the expected variability is representative or an outlier; and
excluding any metrology data relating to a substrate and/or portion thereof assessed to be an outlier from being used for feedback control of the lithographic process.

12. A method as claimed in claim 11, wherein said excluding metrology data comprises not measuring substrate and/or portion thereof assessed to be an outlier.

13. A method as claimed in claim 11, wherein said excluding metrology data comprises designating said substrate and/or portion thereof assessed to be an outlier for monitoring only, such that said substrate and/or portion thereof is measured but the resultant metrology data not used for said feedback control of the lithographic process.

14. A method as claimed in claim 13, wherein said resultant metrology data is assessed to determine whether said substrate requires rework.

15. A computer program comprising program instructions operable to perform the method of any preceding claim, when run on a suitable apparatus.
